# FASCICULE DE BREVET EUROPEEN

(11) **EP 3 633 336 B1**
(45) Date de publication et mention de la délivrance du brevet: **13.12.2023**
(21) Numéro de dépôt: 19201303.5
(22) Date de dépôt: 03.10.2019
(51) Int. Cl.: G01J 5/04, G01J 5/34, G01J 5/02

(54) **DISPOSITIF DE DETECTION PYROELECTRIQUE A MEMBRANE RIGIDE**
PYROELEKTRISCHE DETEKTIONSVORRICHTUNG MIT STARRER MEMBRAN
PYROELECTRIC DETECTION DEVICE WITH RIGID MEMBRANE

(30) Priorité: 05.10.2018 FR 1859236
(43) Date de publication de la demande: 08.04.2020
(73) Titulaire: Commissariat à l'énergie atomique et aux énergies alternatives, 75015 Paris (FR)
(72) Inventeur: LE RHUN, Gwenaël, 38054 GRENOBLE CEDEX 09 (FR); FANGET, Stéphane, 38054 GRENOBLE CEDEX 09 (FR); ROUZAUD, André, 38054 GRENOBLE CEDEX 09 (FR)
(74) Mandataire: Brevalex

(56) Documents cités:
- WO-A1-2015/141496
- CN-U- 205 785 542
- DE-U1-202005 000 617
- JP-A- 2000 213 991
- US-A1- 2006 273 256
- US-A1- 2011 182 320
- WU QINQIN ET AL: "Low cost and anti-noise infrared device based on saw-tooth thermal isolation structure", SENSORS AND ACTUATORS A: PHYSICAL, vol. 266, 14 septembre 2017 (2017-09-14), pages 178-184, XP085244382, ISSN: 0924-4247, DOI: 10.1016/J.SNA.2017.09.025

## Description

### DOMAINE TECHNIQUE ET ART ANTÉRIEUR

L'invention porte sur un dispositif de détection pyroélectrique à membrane rigide, ainsi qu'un procédé de réalisation d'un tel dispositif. L'invention s'applique avantageusement au domaine de la détection infrarouge (IR), pour réaliser par exemple une détection de gaz ou pour former un imageur infrarouge servant par exemple à réaliser une détection de mouvement ou une détection de présence.

Dans un dispositif de détection pyroélectrique tel qu'un dispositif de détection infrarouge, un rayonnement infrarouge reçu par un matériau pyroélectrique du dispositif induit un changement de température de ce matériau. Ce changement de température entraîne une variation de polarisation du matériau pyroélectrique, créant la circulation d'un courant électrique à travers ce matériau et permettant d'obtenir, à la sortie du dispositif, une tension.

Le matériau pyroélectrique présente une polarisation spontanée dont l'amplitude varie en fonction de la température. Une variation de charges électriques peut donc être mesurée lorsque l'intensité du flux infrarouge reçu varie.

La réalisation d'un tel dispositif de détection pyroélectrique repose sur des procédés technologiques classiquement utilisés pour fabriquer des dispositifs MEMS (microsystème électromécanique). Le substrat utilisé comporte généralement du silicium mais d'autres matériaux peuvent être utilisés (verre, saphir, substrat souple en polymère, etc.).

Afin d'avoir une bonne isolation thermique entre le matériau pyroélectrique et le substrat, et limiter ainsi les pertes par conduction thermique à travers le substrat, il est possible de graver le substrat pour former une membrane suspendue sur laquelle repose le matériau pyroélectrique. Le document « Pyroelectric thin film sensor array » de M. Kohli, Sensors and Actuators A : Physical, vol. 60, Issues 1-3, pages 147-153, Mai 1997, décrit un dispositif de détection infrarouge ainsi réalisé.

Dans le document « Design, fabrication and characterization of pyroelectric thin film and its application for infrared gas sensors » de T. Qiu-Lin et al, Microelectronics Journal, vol. 40, Issue 1, pages 58-62, Janvier 2009, il est décrit qu'un problème lié à ce type de dispositif comprenant un matériau pyroélectrique disposé sur une membrane suspendue réside dans sa sensibilité aux contraintes et aux vibrations mécaniques car tous les matériaux pyroélectriques sont également piézoélectriques. Un courant parasite est donc généré dans le matériau pyroélectrique à cause des contraintes et des vibrations mécaniques subies par le dispositif en raison des propriétés piézoélectriques du matériau pyroélectrique. La génération d'un tel courant parasite est appelée effet microphonique ou microphonie. Les variations de la température ambiante et de la luminosité auxquelles le détecteur est exposé peuvent générer également un signal parasite qui se superpose au signal de tension de sortie du détecteur correspondant à la mesure réalisée.

Une réponse possible à ces problèmes qui est proposée dans ce document est de réaliser, sur la membrane suspendue, deux éléments de détection pyroélectrique disposés côte à côte sur la membrane suspendue, formant deux empilements comprenant chacun une portion de matériau pyroélectrique disposée entre une électrode avant et une électrode arrière, de dimensions identiques et reliés électriquement en série l'un à l'autre par leurs électrodes avant. Dans cette configuration, le dispositif est peu sensible aux interférences de mode commun telles que la sensibilité à l'accélération provoquée par la vibration mécanique, car les directions de la polarisation induite dans les deux éléments de détection sont opposées. Un tel dispositif permet donc d'améliorer la capacité de détection. Toutefois, cette amélioration de la capacité de détection nécessite la réalisation de deux éléments de détection côte à côte, ce qui est encombrant et coûteux à réaliser.

Dans le document « Pyroelectric devices and materials » de R. Whatmore, Rep. Prog. Phys. 49 (1986), pages 1335-1386, d'autres solutions sont également proposées pour minimiser le bruit lié à cet effet piézoélectrique dans les dispositifs de détection infrarouge à matériau pyroélectrique. Chacune des différentes solutions proposées dans ce document présente toutefois au moins l'un des inconvénients suivants :
- besoin d'un packaging très rigide dans lequel le détecteur pyroélectrique est disposé ;
- besoin d'utiliser une structure de compensation ;
- besoin de suspendre le détecteur sur un film polymère qui tendrait à découpler le détecteur vis-à-vis des déformations liées au packaging ;
- besoin d'utiliser un matériau pyroélectrique présentant des faibles coefficients piézoélectriques. Une autre solution est de réaliser un élément de rigidification de la membrane comme décrit dans JP 2000 213991 A.

### EXPOSÉ DE L'INVENTION

Un but de la présente invention est de proposer un dispositif de détection pyroélectrique permettant d'éviter ou réduire les courants parasites générés par effet microphonique et ne présentant pas les inconvénients de l'art antérieur exposés ci-dessus.

Pour cela, il est proposé un dispositif de détection pyroélectrique, selon la revendication 1.

Il est donc proposé une structure membrane pyroélectrique à base de matériau piézoélectrique qui permette de réduire voire éliminer le bruit piézoélectrique, c'est-à-dire les charges électriques générées par effet piézoélectrique direct lorsque la membrane vibre (sous l'effet d'un choc par exemple). Pour cela, il est proposé de rigidifier la membrane grâce à un élément de rigidification disposé dans la cavité et sur lequel repose la membrane. Cet élément de rigidification permet de diminuer ou d'empêcher la flexion de la membrane lorsqu'elle est soumise à des contraintes ou des vibrations mécaniques, ce qui réduit ou supprime les courants parasites générés. Les charges électriques éventuellement générées par un choc sont idéalement nulles ou en tout cas très faibles voire négligeables.

De plus, du fait que l'élément de rigidification ne remplit que partiellement la cavité, l'espace de la cavité non occupé par l'élément de rigidification permet de conserver une bonne isolation thermique entre le matériau pyroélectrique et le substrat, et limiter ainsi les pertes par conduction thermique à travers le substrat.

Le dispositif de détection pyroélectrique peut correspondre à un capteur pyroélectrique infrarouge, utilisé par exemple pour réaliser une détection de gaz, ou un imageur infrarouge.

La membrane, qui comprend par exemple une ou plusieurs couches dite(s) élastique(s), permet la tenue mécanique de l'élément de détection pyroélectrique.

L'élément de détection pyroélectrique forme un condensateur à base de matériau pyroélectrique disposé entre deux électrodes.

Dans l'ensemble du document, le terme « sur » est utilisé sans distinction de l'orientation dans l'espace de l'élément auquel ce rapporte ce terme. Par exemple, dans la caractéristique « un élément de détection pyroélectrique disposé sur la membrane », la face de la membrane sur laquelle l'élément de détection pyroélectrique est disposé n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

Le dispositif de détection pyroélectrique est par exemple de type MEMS (microsystème électromécanique) ou NEMS (nanosystème électromécanique).

La membrane comporte une ou plusieurs couches de matériaux. Selon l'invention, l'élément de rigidification peut être formé au moins par une ou plusieurs portions du substrat. Dans ce cas, cette ou ces portions de matériau issues du substrat peuvent être formées par exemple en ne libérant que partiellement la membrane lors d'une gravure discontinue du substrat mise en oeuvre lors de la réalisation de la cavité.

L'élément de rigidification peut comporter plusieurs portions distinctes de forme allongée et s'étendant dans la cavité entre les bords latéraux selon une ou plusieurs directions. Une telle configuration est avantageuse car elle autorise la réalisation de l'élément de rigidification selon des géométries offrant un bon maintien mécanique de la membrane tout en conservant une bonne isolation thermique entre le matériau pyroélectrique et le substrat.

Selon l'invention, un rapport entre la surface de la partie de la membrane formant la paroi de fond de la cavité qui est en contact avec l'élément de rigidification et la surface totale de la partie de la membrane formant la paroi de fond de la cavité peut être compris entre 0,05 et 0,6. Une telle configuration est avantageuse car l'élément de rigidification offre dans ce cas un bon compromis entre un bon maintien mécanique de la membrane et une faible conduction thermique par l'élément de rigidification entre le matériau pyroélectrique et le substrat.

Selon un premier mode de réalisation, l'élément de détection pyroélectrique peut être disposé sur la membrane qui comporte au moins une couche de matériau distincte de l'élément de détection pyroélectrique.

Dans ce cas, la couche de matériau de la membrane peut comporter du SiO₂ et/ou du Si et/ou du SiN.

Selon un deuxième mode de réalisation, la membrane peut faire partie de l'élément de détection pyroélectrique et peut être formée au moins par la première électrode sur laquelle repose la portion de matériau piézoélectrique.

L'élément de détection pyroélectrique peut comporter un corps noir formé par la deuxième électrode qui est configurée pour recevoir un rayonnement infrarouge incident destiné à être détecté par le dispositif et/ou par une portion de matériau absorbeur de rayonnement infrarouge telle que la deuxième électrode soit disposée entre la portion de matériau absorbeur de rayonnement infrarouge et la portion de matériau pyroélectrique.

Ainsi, la deuxième électrode peut servir à la fois d'électrode et d'absorbeur de rayonnement infrarouge. Le matériau de la deuxième électrode peut être différent de celui de la première électrode, et/ou l'épaisseur de la deuxième électrode peut être différente de celle de la première électrode, notamment lorsque la deuxième électrode sert à la fois d'électrode et d'absorbeur de rayonnement infrarouge. Par exemple, la première électrode peut comporter du platine, et la deuxième électrode peut comporter un matériau configuré pour que la deuxième électrode remplisse les fonctions d'électrode et d'absorbeur de rayonnement infrarouge, comme par exemple du Ni, du Ni-Cr ou du TiN.

Le corps noir correspond à un élément absorbant l'énergie électromagnétique reçue par le dispositif de détection pyroélectrique.

Le matériau absorbeur de rayonnement infrarouge peut comporter du TiN et/ou du Ni-Cr et/ou du Ni et/ou du métal noir (noir de platine, or noir,...).

Le dispositif peut être tel que :
- le matériau pyroélectrique correspond à au moins l'un des matériaux suivants : PZT (Titano-Zirconate de Plomb, ou Pb(Zr_{X},Ti_{1-X})O₃), PZT dopé (Mn, La, Nb,...), AIN, KNN ((K, Na)NbO₃), NBT-BT ((1-x)Na_{0,5}Bi_{0,5}TiO₃- xBaTiO₃), PMN-PT (Pb(Mg_{1/3}Nb_{2/3})O₃-PbTiO₃), LTO (Tantalate de lithium, ou LiTaO₃), LNO (Niobate de lithium, ou LiNbO₃), PVDF, et/ou
- la première électrode comporte un métal (avantageusement du platine, notamment lorsque le matériau pyroélectrique comporte du PZT car il permet dans ce cas d'assurer une bonne croissance du matériau PZT) et/ou un oxyde métallique, et/ou
- la deuxième électrode comporte au moins l'un des matériaux suivants : Pt, Ru, Ir, TiW, Au, Ni, Ni-Cr, TiN.

L'invention concerne également un procédé de réalisation d'un dispositif de détection pyroélectrique, selon la revendication 9.

De manière avantageuse, la cavité et l'élément de rigidification peuvent être réalisés par une même étape de gravure depuis une face arrière du substrat.

Selon un premier mode de réalisation, la réalisation de la membrane peut comporter une étape de réalisation, sur le substrat, d'au moins une couche de matériau destinée à former la membrane et sur laquelle l'élément de détection pyroélectrique est ensuite réalisé.

Dans ce cas, la couche de matériau peut être réalisée par oxydation thermique du substrat qui comporte au moins un semi-conducteur, et/ou par dépôt de SiO₂ sur le substrat.

De plus, la réalisation de l'élément de détection pyroélectrique peut comporter la mise en oeuvre des étapes suivantes :
- réalisation d'au moins une première couche d'électrode sur la couche de matériau ;
- réalisation d'au moins une couche du matériau pyroélectrique sur la première couche d'électrode ;
- réalisation d'au moins une deuxième couche d'électrode sur la couche du matériau pyroélectrique ;
- structuration de chacune des première et deuxième couches d'électrodes et de la couche du matériau pyroélectrique telle que des portions restantes de ces couches forment l'élément de détection pyroélectrique.

Selon un deuxième mode de réalisation, la membrane suspendue peut être obtenue par la mise en oeuvre des étapes suivantes :
- réalisation, sur le substrat, d'au moins une première couche d'électrode ;
- réalisation d'au moins une couche du matériau pyroélectrique sur la première couche d'électrode ;
- réalisation d'au moins une deuxième couche d'électrode sur la couche de matériau pyroélectrique ;
- structuration de la deuxième couche d'électrode et de la couche du matériau pyroélectrique telle que des portions restantes de la deuxième couche d'électrode et de la couche du matériau pyroélectrique forment, avec la première couche d'électrode, l'élément de détection pyroélectrique ;
et dans lequel la membrane peut faire partie de l'élément de détection pyroélectrique et peut être formée au moins par la première couche d'électrode.

Le procédé peut comporter en outre, entre l'étape de dépôt de la deuxième couche d'électrode et l'étape de structuration, une étape de dépôt d'au moins une couche de matériau absorbeur de rayonnement infrarouge sur la deuxième couche d'électrode, et l'étape de structuration peut également être mise en oeuvre pour la couche de matériau absorbeur de rayonnement infrarouge telle qu'une portion restante de cette couche de matériau absorbeur de rayonnement infrarouge disposée sur la deuxième électrode fasse partie d'un corps noir de l'élément de détection pyroélectrique.

La deuxième couche d'électrode peut comporter une épaisseur et un matériau tels que la deuxième électrode fasse partie du corps noir de l'élément de détection pyroélectrique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un dispositif de détection pyroélectrique selon un premier mode de réalisation ;
- la figure 2 représente plusieurs exemples de réalisation de l'élément de rigidification d'un dispositif de détection pyroélectrique selon un mode de réalisation particulier ;
- les figures 3 et 4 représentent des étapes d'un procédé de réalisation d'un dispositif de détection pyroélectrique selon le premier mode de réalisation ;
- la figure 5 représente un dispositif de détection pyroélectrique selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

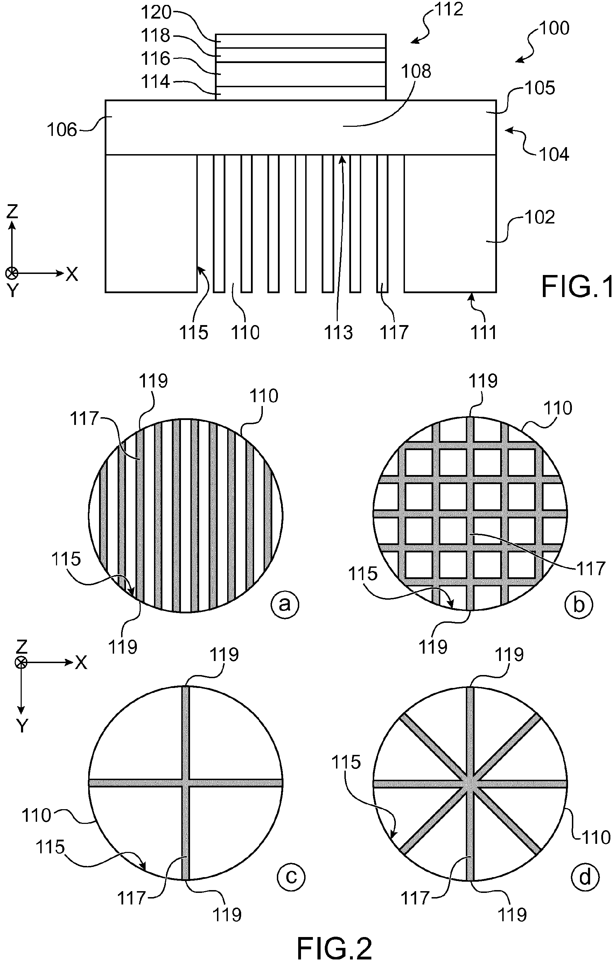

On se réfère à la figure 1 qui représente un dispositif 100 de détection pyroélectrique selon un premier mode de réalisation.

Le dispositif 100 comporte un substrat 102. Le substrat 102 comporte avantageusement du semi-conducteur, par exemple du silicium.

Le dispositif 100 comporte également une membrane 104. Dans le premier mode de réalisation décrit ici, la membrane 104 comporte une ou plusieurs couches 105 dites élastiques comprenant au moins l'un des matériaux suivants : SiOz, Si, SiN. La membrane 104 comporte des bords 106, ou extrémités, solidaires du substrat 102, et une partie 108 disposée en regard d'une cavité 110 formée à travers le substrat 102. Par exemple, la membrane 104 peut être formée par une couche 105 de SiOz, ou un bicouche SiOz/SiN, dont l'épaisseur est par exemple comprise entre environ 10 nm et 100 µm.

La cavité 110 traverse le substrat 102 depuis une face arrière 111 du substrat 102 et débouche en regard de la partie 108 de la membrane 104 qui forme une paroi de fond 113 de la cavité 110. La cavité 110 comprend des bords latéraux 115 formés par le substrat 102.

Dans la configuration représentée sur la figure 1, la membrane 104 est solidaire du substrat 102 au niveau de ses bords 106. En variante, il est possible que la membrane 104 soit solidarisée au substrat 102 par l'intermédiaire de bras par exemple formés par des portions de matériau s'étendant entre certaines parties de la membrane 104 et le substrat 102.

Le dispositif 100 comporte également un élément de détection pyroélectrique 112 disposé sur la membrane 104. La membrane 104 assure la tenue mécanique de l'élément 112. Cet élément 112 comporte :
- une électrode inférieure 114, également appelée première électrode ;
- une portion 116 de matériau pyroélectrique ;
- une électrode supérieure 118, également appelée deuxième électrode ;
- une portion 120 de matériau absorbeur de rayonnement infrarouge.

L'électrode inférieure 114 est disposée sur la membrane 104. La portion 116 de matériau pyroélectrique est disposée entre les électrodes inférieure et supérieure 114, 118. La portion 120 de matériau absorbeur de rayonnement infrarouge est disposée sur l'électrode supérieure 118.

L'électrode inférieure 114 comporte avantageusement du platine, ce qui facilite la croissance du matériau pyroélectrique de la portion 116 lors de sa réalisation. L'électrode supérieure 118 comporte par exemple au moins l'un des matériaux suivants : Pt, Ru, Ir, TiW, Au. Chacune des électrodes inférieure 114 et supérieure 118 a une épaisseur par exemple comprise entre environ 2 nm et 200 nm. Bien que non visible, une couche d'adhésion peut être disposée entre la membrane 104 et l'électrode inférieure 114. Cette couche d'adhésion comprend par exemple du TiOz ou tout autre matériau adapté pour que l'électrode inférieure 114 adhère bien à la membrane 104, et a par exemple une épaisseur comprise entre environ 2 nm et 40 nm.

La portion 116 de matériau pyroélectrique comporte avantageusement du PZT, mais peut comporter plus généralement au moins l'un des matériaux suivants : PZT, AIN, KNN, NBT-BT, PMN-PT, LTO, LNO, PVDF. Le PZT peut être dopé, par exemple avec du Nb, du Mn ou du La. L'épaisseur de la portion 116 de matériau pyroélectrique est par exemple comprise entre environ 50 nm et 2 µm.

La portion 120 de matériau absorbeur comporte au moins l'un des matériaux suivants : TiN et/ou du Ni-Cr et/ou du Ni et/ou du métal noir (noir de platine, or noir, ...). L'épaisseur de la portion 120 est par exemple comprise entre environ 1 nm et 5 µm.

Le matériau pyroélectrique de la portion 116 étant aussi piézoélectrique, il peut générer des charges par effet piézoélectrique direct, par exemple sous l'effet d'une contrainte mécanique, d'un choc, voire lors d'un changement de température entraînant une déformation de ce matériau. Ces charges peuvent parasiter le fonctionnement d'un élément de détection pyroélectrique car elles vont s'ajouter aux charges générées par l'effet pyroélectrique lors de la détection d'un rayonnement incident par cet élément.

Pour éliminer ces charges parasites, ou du moins les réduire, le dispositif 100 comporte également un élément de rigidification 117 de la membrane 104. Cet élément 117 est disposé dans la cavité 110 et remplit partiellement la cavité 110. Cet élément 117 est solidarisé aux bords latéraux 115 de la cavité 110 au niveau d'au moins deux régions d'ancrage distinctes. En outre, cet élément 117 est disposé contre la membrane 104, c'est-à-dire que la membrane 104 repose sur cet élément 117.

De manière avantageuse, l'élément 117 comporte des portions du substrat 102 qui n'ont pas été gravées lors de la réalisation de la cavité 110.

De manière avantageuse, chacune des portions de matériau formant l'élément 117 a une forme allongée et s'étend dans la cavité 110 entre les bords latéraux 115. Chacune de ces portions a par exemple une forme de lame ou d'ailette.

Différents exemples de réalisation de l'élément de rigidification 117 sont représentés sur la figure 2.

Sur l'exemple de réalisation référencé a) de la figure 2, l'élément de rigidification 117 comporte plusieurs portions de matériau disposées dans la cavité 110, chacune ayant une forme allongée et étant solidarisée aux bords latéraux 115 de la cavité 110 au niveau de deux points d'ancrage 119 distincts. Dans cet exemple de réalisation, les portions de matériau de l'élément 117 s'étendent selon une même direction, c'est-à-dire correspondent à des portions de forme allongée disposées parallèlement les unes des autres (parallèlement à l'axe Y sur la figure 2).

Sur l'exemple de réalisation référencé b) de la figure 2, l'élément de rigidification 117 comporte plusieurs portions de matériau disposées dans la cavité 110, chacune ayant une forme allongée et étant solidarisée aux bords latéraux 115 de la cavité 110 au niveau de deux points d'ancrage 119 distincts. Dans cet exemple de réalisation, les portions de matériau de l'élément 117 s'étendent selon deux directions perpendiculaires l'une par rapport à l'autre (chacune parallèle à l'un des axes X et Y sur la figure 2). Dans cet exemple de réalisation, les portions de matériau de l'élément 117 forment ensemble rigide en forme de quadrillage et ancré aux bords latéraux 115 de la cavité 110 et sur lequel repose la membrane 104.

Sur l'exemple de réalisation référencé c) de la figure 2, l'élément de rigidification 117 comporte deux portions de matériau disposées dans la cavité 110, chacune ayant une forme allongée et étant solidarisée aux bords latéraux 115 de la cavité 110 au niveau de deux points d'ancrage 119 distincts. Dans cet exemple de réalisation, l'une de ces deux portions s'étend selon une première direction (parallèlement à l'un des axes X et Y sur la figure 2), et l'autre s'étend selon une deuxième direction perpendiculaire à la première direction (parallèlement à l'autre des axes X et Y sur la figure 2). Dans cet exemple de réalisation, les portions de matériau de l'élément 117 forment un ensemble rigide en forme croix comportant ses quatre extrémités solidarisées aux bords latéraux 115 de la cavité 110 et sur lequel repose la membrane 104.

Sur l'exemple de réalisation référencé d) de la figure 2, l'élément de rigidification 117 comportent trois portions de matériau disposées dans la cavité 110, chacune ayant une forme allongée et étant solidarisée aux bords latéraux 115 de la cavité 110 au niveau de deux points d'ancrage 119 distincts. Dans cet exemple de réalisation, les portions de matériau de l'élément 117 s'étendent selon différentes directions de manière à former un ensemble rigide en forme d'étoile comportant ses extrémités solidarisées aux bords latéraux 115 de la cavité 110 et sur lequel repose la membrane 104.

En variante, l'élément de rigidification 117 peut être réalisé différemment des exemples décrits ci-dessus.

Quelle que soit la forme, le nombre et la disposition de la ou des portions de matériau formant l'élément de rigidification 117 dans la cavité 110, cette ou ces portions de matériau sont avantageusement réalisées telles que l'élément de rigidification 117 assure un maintien mécanique suffisant de la membrane 104, tout en limitant les surfaces de contact avec la membrane 104 afin de conserver une bonne isolation thermique de la membrane 104 vis-à-vis du substrat 102. Pour obtenir un tel compromis, le rapport entre la surface de la partie de la membrane formant la paroi de fond 113 de la cavité 110 qui est en contact avec l'élément 117 de rigidification et la surface totale de la partie 108 de la membrane 104 formant la paroi de fond 113 de la cavité 110 est avantageusement compris entre environ 0,05 et 0,6.

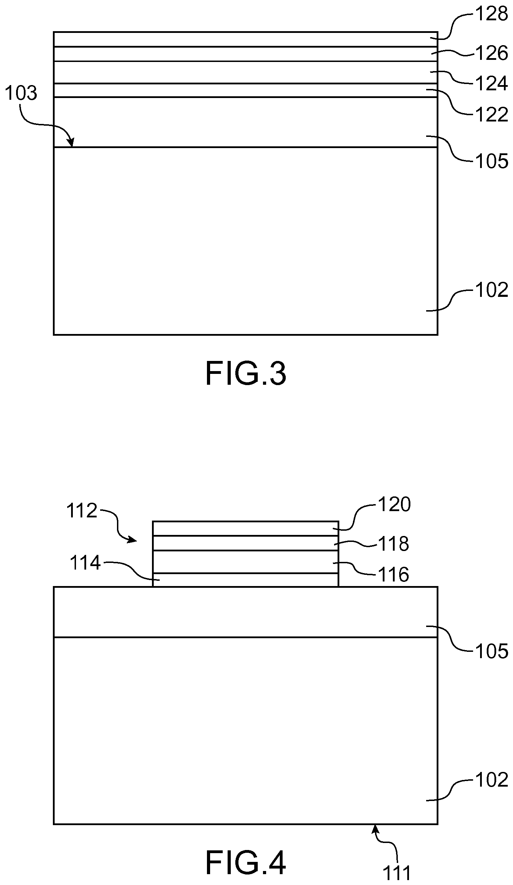

Un exemple d'un procédé de réalisation du dispositif 100 est décrit ci-dessous en lien avec les figures 3 et 4.

Comme représenté sur la figure 3, une (ou plusieurs) couche 105 de matériau destinée à former la membrane suspendue est réalisée sur une face avant 103 du substrat 102. Dans l'exemple de réalisation décrit ici, le substrat 102 comporte du silicium et la couche 105 comporte du SiO₂. Selon un premier exemple, la couche 105 peut être réalisée par oxydation thermique depuis la face avant 103 du substrat 102. Selon un deuxième exemple, la couche 105 peut être formée par un dépôt, par exemple PECVD (dépôt chimique en phase vapeur assisté par plasma), de SiO₂, avantageusement suivi d'une densification correspondant par exemple à un recuit dans un four sous oxygène, à une température par exemple égale à environ 800°C et pendant une durée égale à environ 3 heures.

Au moins une première couche d'électrode 122 destinée à former l'électrode inférieure 114 est ensuite déposée sur la couche 105. Dans l'exemple de réalisation décrit ici, la première couche d'électrode 122 comporte du platine. De manière avantageuse, le dépôt de cette première couche d'électrode 122 est précédé d'un dépôt d'une couche d'accroche (non visible sur la figure 3) correspondant par exemple à une couche de TiO₂ déposée sur la couche 105, la première couche d'électrode 122 étant ensuite déposée sur cette couche d'accroche.

Au moins une couche 124 du matériau pyroélectrique destinée à former la portion 116 de matériau pyroélectrique est ensuite déposée sur la première couche d'électrode 122. Cette couche 124 est par exemple formée par un procédé de type sol-gel ou par pulvérisation cathodique ou encore par ablation laser pulsé.

Au moins une deuxième couche d'électrode 126, comprenant par exemple du platine, destinée à former l'électrode supérieure 118 est ensuite déposée sur la couche 124.

Une couche 128 de matériau absorbeur de rayonnement infrarouge destinée à former la portion 120 est ensuite déposée sur la deuxième couche d'électrode 126.

Une structuration de chacune des couches 122, 124, 126 et 128 est ensuite mise en oeuvre, par exemple par lithographie, gravure et stripping, telle que les portions restantes 114, 116, 118 et 120 de ces couches forment l'élément 112 de détection pyroélectrique (voir figure 4).

Une gravure est ensuite mise en oeuvre depuis la face arrière 111 du substrat 102 afin de former la cavité 110 et l'élément de rigidification 117. Cette gravure correspond par exemple à une gravure ionique réactive profonde (DRIE). Le matériau du substrat 102 se trouvant dans la région délimitée par les bords latéraux 115 de la cavité 110 est gravé de manière discontinue afin de conserver des portions de matériau du substrat 102 pour former l'élément de rigidification 117. La membrane 104 n'est donc que partiellement libérée par la mise en oeuvre de cette gravure.

Le dispositif 100 obtenu à l'issue de ce procédé correspond à celui représenté sur la figure 1.

Dans le premier mode de réalisation représenté sur la figure 1, la largeur (dimension selon l'axe X représenté sur la figure 1), ou le diamètre, de l'élément 112 est inférieure à celle de la cavité 110. Les bords de l'élément 112 ne reposent pas sur le substrat 102 et sont disposés en regard de la cavité 110 et non des parties du substrat 102 se trouvant autour de la cavité 110. Cette configuration est avantageuse car elle permet d'améliorer l'isolation thermique de l'élément 112 vis-à-vis du substrat 102.

En variante, il est toutefois possible que la largeur, ou le diamètre, de l'élément 112 soit supérieure à celle de la cavité 110. Dans ce cas, les bords de l'élément 112 reposent sur les parties du substrat 102 entourant la cavité 110.

Dans le premier mode de réalisation précédemment décrit, le dispositif 100 comporte un élément absorbeur formé par la portion 120. En variante, il est possible que l'électrode supérieure 118 sert d'élément absorbeur de rayonnement infrarouge. Dans ce cas, l'électrode supérieure 118 comporte avantageusement du Ni et/ou du NiCr et/ou du TiN.

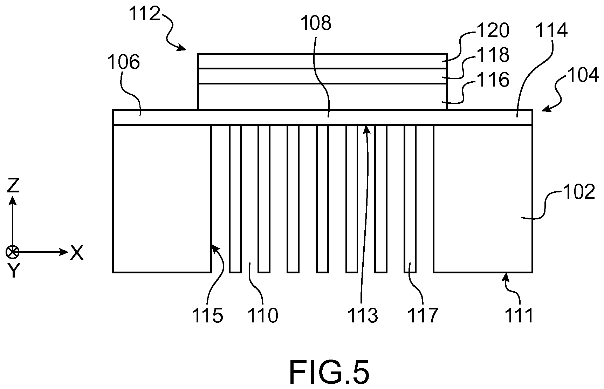

Un dispositif 100 de détection pyroélectrique selon un deuxième mode de réalisation est décrit ci-dessous en lien avec la figure 5.

Par rapport au dispositif 100 selon le premier mode de réalisation précédemment décrit, le dispositif 100 selon le deuxième mode de réalisation ne comporte pas la couche 105 servant à former la membrane 104. Dans ce deuxième mode de réalisation, la couche formant l'électrode inférieure 114 forme également la membrane 104. En variante, il est possible que d'autres parties de l'élément 112 (portion 116 et/ou électrode supérieure 118) forment la membrane 104.

Comme dans le premier mode de réalisation, un ou plusieurs éléments 117 de rigidification de la membrane 104 sont disposés dans la cavité 110.

Les différentes variantes décrites précédemment en lien avec le premier mode de réalisation peuvent s'appliquer à ce deuxième mode de réalisation.

Dans les exemples de réalisation précédemment décrits, l'élément de rigidification 117 comporte des portions de matériau issues du substrat 102 et obtenues lors de la réalisation de la cavité 110 en gravant partiellement le matériau du substrat 102 se trouvant dans le volume de la cavité 110 afin que la ou les portions restantes non gravées forment la ou les portions de matériau de l'élément de rigidification. En variante, il est possible que l'élément de rigidification 117 comporte des portions de matériau qui ne soient pas issues du substrat 102 mais qui sont réalisées dans la cavité 110 après avoir gravé totalement le matériau du substrat 102 se trouvant dans le volume de la cavité 110. Dans ce cas, la cavité 110 peut être remplie par du matériau, par exemple différent de celui du substrat 102, qui est ensuite mis en forme par des étapes de lithographie et gravure pour former l'élément de rigidification 117. Ce matériau peut être choisi en fonction de sa conduction thermique suivant que l'on souhaite favoriser l'isolation (en choisissant dans ce cas par exemple un polymère ou du SiO₂) ou la conduction thermique (en choisissant dans ce cas par exemple du silicium).

Dans les modes de réalisation du dispositif 100 précédemment décrits, l'épaisseur (dimension parallèle à l'axe Z sur les figures 1 à 5) de l'élément de rigidification 117 est égale à l'épaisseur du substrat 102, par exemple égale à 725 µm pour un substrat standard de 200 mm de diamètre. En variante, il est possible que l'épaisseur de l'élément de rigidification 117 soit inférieure à l'épaisseur initiale du substrat 102, par exemple lorsqu'un amincissement est mis en oeuvre depuis la face arrière 111 du substrat 102 ou lorsque la gravure mise en oeuvre pour former la cavité 110 grave également une partie de l'épaisseur du matériau de l'élément de rigidification 117. Il est également possible que les différentes portions de matériau formant l'élément de rigidification 117 n'aient pas les mêmes épaisseurs les unes par rapport aux autres.

## Revendications

1. Dispositif (100) de détection pyroélectrique, comprenant au moins :
- un substrat (102) ;
- une membrane (104) disposée sur le substrat (102) ;
- un élément (112) de détection pyroélectrique disposé sur la membrane (104) ou formant au moins une partie de la membrane (104), et comprenant au moins une portion (116) de matériau pyroélectrique disposée entre des première et deuxième électrodes (114, 118) ;
- une cavité (110) traversant le substrat (102), débouchant en regard d'une partie (108) de la membrane (104) qui forme une paroi de fond (113) de la cavité (110), et comprenant des bords latéraux (115) formés par le substrat (102) ;
- un élément (117) de rigidification de la membrane (104) disposé dans la cavité (110), remplissant partiellement la cavité (110), solidarisé aux bords latéraux (115) de la cavité (110) au niveau d'au moins deux régions d'ancrage (119) distinctes, et disposé contre la membrane (104) ;
dans lequel l'élément (117) de rigidification est formé au moins par une ou plusieurs portions du substrat (102), et dans lequel un rapport entre la surface de la partie (108) de la membrane (104) formant la paroi de fond (113) de la cavité (110) qui est en contact avec l'élément (117) de rigidification et la surface totale de la partie (108) de la membrane (104) formant la paroi de fond (113) de la cavité (110) est compris entre 0,05 et 0,6.

2. Dispositif (100) selon l'une des revendications précédentes, dans lequel l'élément (117) de rigidification comporte plusieurs portions distinctes de forme allongée et s'étendant dans la cavité (110) entre les bords latéraux (115) selon une ou plusieurs directions.

3. Dispositif (100) selon l'une des revendications précédentes, dans lequel l'élément (112) de détection pyroélectrique est disposé sur la membrane (104) qui comporte au moins une couche (105) de matériau distincte de l'élément (112) de détection pyroélectrique.

4. Dispositif (100) selon la revendication 3, dans lequel la couche (105) de matériau de la membrane (104) comporte du SiO₂ et/ou du Si et/ou du SiN.

5. Dispositif (100) selon l'une des revendications 1 ou 2, dans lequel la membrane (104) fait partie de l'élément (112) de détection pyroélectrique et est formée au moins par la première électrode (114) sur laquelle repose la portion (116) de matériau piézoélectrique.

6. Dispositif (100) selon l'une des revendications précédentes, dans lequel l'élément (112) de détection pyroélectrique comporte un corps noir formé par la deuxième électrode (118) qui est configurée pour recevoir un rayonnement infrarouge incident destiné à être détecté par le dispositif (100) et/ou par une portion (120) de matériau absorbeur de rayonnement infrarouge telle que la deuxième électrode (118) soit disposée entre la portion (120) de matériau absorbeur de rayonnement infrarouge et la portion (116) de matériau pyroélectrique.

7. Dispositif (100) selon la revendication 6, dans lequel le matériau absorbeur de rayonnement infrarouge comporte du TiN et/ou du Ni-Cr et/ou du Ni et/ou du métal noir.

8. Dispositif (100) selon l'une des revendications précédentes, dans lequel :
- le matériau pyroélectrique correspond à au moins l'un des matériaux suivants : PZT, PZT dopé, AIN, KNN, NBT-BT, PMN-PT, LTO, LNO, PVDF et/ou
- la première électrode (114) comporte un métal et/ou un oxyde métallique, et/ou
- la deuxième électrode (118) comporte au moins l'un des matériaux suivants : Pt, Ru, Ir, TiW, Au, Ni, Ni-Cr, TiN.

9. Procédé de réalisation d'un dispositif (100) de détection pyroélectrique, comprenant au moins :
- réalisation, sur un substrat (102), d'une membrane (104) et d'un élément (112) de détection pyroélectrique tel qu'il soit disposé sur la membrane (104) ou qu'il forme au moins une partie de la membrane (104), et comprenant au moins une portion (116) de matériau pyroélectrique disposée entre des première et deuxième électrodes (114, 118) ;
- réalisation d'au moins une cavité (110) traversant le substrat (102), débouchant en regard d'une partie (108) de la membrane (104) qui forme une paroi de fond (113) de la cavité (110), et comprenant des bords latéraux (115) formés par le substrat (102) ;
- réalisation d'au moins un élément (117) de rigidification de la membrane (104) disposé dans la cavité (110), remplissant partiellement la cavité (110), solidarisé aux bords latéraux (115) de la cavité (110) au niveau d'au moins deux régions d'ancrage (119) distinctes, et disposé contre la membrane (104) ;
dans lequel l'élément (117) de rigidification est formé au moins par une ou plusieurs portions du substrat (102), et dans lequel un rapport entre la surface de la partie (108) de la membrane (104) formant la paroi de fond (113) de la cavité (110) qui est en contact avec l'élément (117) de rigidification et la surface totale de la partie (108) de la membrane (104) formant la paroi de fond (113) de la cavité (110) est compris entre 0,05 et 0,6.

10. Procédé selon la revendication 9, dans lequel la cavité (110) et l'élément (117) de rigidification sont réalisés par une même étape de gravure depuis une face arrière (111) du substrat (102).

11. Procédé selon l'une des revendications 9 ou 10, dans lequel la réalisation de la membrane (104) comporte une étape de réalisation, sur le substrat (102), d'au moins une couche (105) de matériau destinée à former la membrane (104) et sur laquelle l'élément (112) de détection pyroélectrique est ensuite réalisé.

12. Procédé selon la revendication 11, dans lequel la couche (105) de matériau est réalisée par oxydation thermique du substrat (102) qui comporte au moins un semi-conducteur, et/ou par dépôt de SiO₂ sur le substrat (102).

13. Procédé selon l'une des revendications 11 ou 12, dans lequel la réalisation de l'élément (112) de détection pyroélectrique comporte la mise en oeuvre des étapes suivantes :
- réalisation d'au moins une première couche d'électrode (122) sur la couche (105) de matériau ;
- réalisation d'au moins une couche (124) du matériau pyroélectrique sur la première couche d'électrode (122) ;
- réalisation d'au moins une deuxième couche d'électrode (126) sur la couche (124) du matériau pyroélectrique ;
- structuration de chacune des première et deuxième couches d'électrodes (122, 126) et de la couche (124) du matériau pyroélectrique telle que des portions restantes (114, 116, 118) de ces couches (122, 124, 126) forment l'élément (112) de détection pyroélectrique.

14. Procédé selon l'une des revendications 9 ou 10, dans lequel la membrane (104) est obtenue par la mise en oeuvre des étapes suivantes :
- réalisation, sur le substrat (102), d'au moins une première couche d'électrode (122);
- réalisation d'au moins une couche (124) du matériau pyroélectrique sur la première couche d'électrode (122) ;
- réalisation d'au moins une deuxième couche d'électrode (126) sur la couche (124) de matériau pyroélectrique ;
- structuration de la deuxième couche d'électrode (126) et de la couche (124) du matériau pyroélectrique telle que des portions restantes (116, 118) de la deuxième couche d'électrode (126) et de la couche (124) du matériau pyroélectrique forment, avec la première couche d'électrode (122), l'élément (112) de détection pyroélectrique ;
et dans lequel la membrane (104) fait partie de l'élément (112) de détection pyroélectrique et est formée au moins par la première couche d'électrode (122).

15. Procédé selon l'une des revendications 13 ou 14, comportant en outre, entre l'étape de dépôt de la deuxième couche d'électrode (126) et l'étape de structuration, une étape de dépôt d'au moins une couche (128) de matériau absorbeur de rayonnement infrarouge sur la deuxième couche d'électrode (126), et dans lequel l'étape de structuration est également mise en oeuvre pour la couche (128) de matériau absorbeur de rayonnement infrarouge telle qu'une portion restante (120) de cette couche (128) de matériau absorbeur de rayonnement infrarouge disposée sur la deuxième électrode (118) fasse partie d'un corps noir de l'élément (112) de détection pyroélectrique.

## Patentansprüche

1. Pyroelektrische Detektionsvorrichtung (100), umfassend mindestens:
- ein Substrat (102);
- eine Membran (104), die auf dem Substrat (102) angeordnet ist;
- ein pyroelektrisches Detektionselement (112), das auf der Membran (104) angeordnet ist, oder mindestens einen Teil der Membran (104) bildet, und mindestens einen Abschnitt (116) aus pyroelektrischem Werkstoff umfasst, der zwischen der ersten und zweiten Elektrode (114, 118) angeordnet ist;
- einen Hohlraum (110), der das Substrat (102) durchquert, gegenüber einem Teil (108) der Membran (104) einmündet, der eine Bodenwand (113) des Hohlraumes (110) bildet, und Seitenränder (115) umfasst, die durch das Substrat (102) gebildet werden;
- ein Versteifungselement (117) der Membran (104), das in dem Hohlraum (110) angeordnet ist, den Hohlraum (110) teilweise ausfüllt, im Bereich mindestens zweier verschiedener Verankerungsregionen (119) fest mit den Seitenrändern (115) des Hohlraums (110) verbunden ist, und an der Membran (104) angeordnet ist;
wobei das Versteifungselement (117) mindestens durch einen oder mehrere Abschnitte des Substrats (102) gebildet wird, und wobei ein Verhältnis zwischen der Oberfläche des Teils (108) der Membran (104), der die Bodenwand (113) des Hohlraumes (110) bildet, die in Kontakt mit dem Versteifungselement (117) ist, und der Gesamtoberfläche des Teils (108) der Membran (104), der die Bodenwand (113) des Hohlraumes (110) bildet, zwischen 0,05 und 0,6 liegt.

2. Vorrichtung (100) nach einem der vorstehenden Ansprüche, wobei das Versteifungselement (117) mehrere separate Abschnitte in länglicher Form und sich in dem Hohlraum (110) zwischen den Seitenrändern (115) in einer oder mehreren Richtungen erstreckend beinhaltet.

3. Vorrichtung (100) nach einem der vorstehenden Ansprüche, wobei das pyroelektrische Detektionselement (112) auf der Membran (104) angeordnet ist, die mindestens eine von dem pyroelektrischen Detektionselement (112) separate Werkstoffschicht (105) beinhaltet.

4. Vorrichtung (100) nach Anspruch 3, wobei die Werkstoffschicht (105) der Membran (104) SiO₂ und/oder Si und/oder SiN beinhaltet.

5. Vorrichtung (100) nach einem der Ansprüche 1 oder 2, wobei die Membran (104) dem pyroelektrischen Detektionselement (112) angehört, und mindestens durch die erste Elektrode (114), auf der der Abschnitt (116) aus piezoelektrischem Werkstoff aufliegt, gebildet wird.

6. Vorrichtung (100) nach einem der vorstehenden Ansprüche, wobei das pyroelektrische Detektionselement (112) einen schwarzen Körper beinhaltet, der durch die zweite Elektrode (118) gebildet wird, die konfiguriert ist, um eine einfallende Infrarotstrahlung zu empfangen, die dazu bestimmt ist, durch die Vorrichtung (100) und/oder durch einen Abschnitt (120) aus einem Infrarotstrahlung absorbierenden Werkstoff erkannt zu werden, sodass die zweite Elektrode (118) zwischen dem Abschnitt (120) aus einem Infrarotstrahlung absorbierenden Werkstoff und dem Abschnitt (116) aus pyroelektrischem Werkstoff angeordnet ist.

7. Vorrichtung (100) nach Anspruch 6, wobei der Infrarotstrahlung absorbierende Werkstoff TiN und/oder Ni-Cr und/oder Ni und/oder schwarzes Metall beinhaltet.

8. Vorrichtung (100) nach einem der vorstehenden Ansprüche, wobei:
- der pyroelektrische Werkstoff mindestens einem der folgenden Werkstoffe entspricht: PZT, dotiertes PZT, AIN, KNN, NBT-BT, PMN-PT, LTO, LNO, PVDF und/oder
- die erste Elektrode (114) ein Metall und/oder ein Metalloxid beinhaltet, und/oder
- die zweite Elektrode (118) mindestens einen der folgenden Werkstoffe beinhaltet: Pt, Ru, Ir, TiW, Au, Ni, Ni-Cr, TiN.

9. Verfahren zum Ausführen einer pyroelektrischen Detektionsvorrichtung (100), mindestens umfassend:
- Ausführen, auf einem Substrat (102), einer Membran (104) und eines pyroelektrischen Detektionselements (112), derart, dass es auf der Membran (104) angeordnet ist, oder es mindestens einen Teil der Membran (104) bildet, und mindestens einen Abschnitt (116) aus pyroelektrischem Werkstoff umfasst, der zwischen der ersten und zweiten Elektrode (114, 118) angeordnet ist;
- Ausführen mindestens eines Hohlraumes (110), der das Substrat (102) durchquert, gegenüber einem Teil (108) der Membran (104) einmündet, der eine Bodenwand (113) des Hohlraumes (110) bildet, und Seitenränder (115) umfasst, die durch das Substrat (102) gebildet werden;
- Ausführen mindestens eines Versteifungselements (117) der Membran (104), das in dem Hohlraum (110) angeordnet ist, den Hohlraum (110) teilweise ausfüllt, im Bereich mindestens zweier separater Verankerungsregionen (119) fest mit den Seitenrändern (115) des Hohlraumes (110) verbunden ist, und an der Membran (104) angeordnet ist; wobei das Versteifungselement (117) mindestens durch einen oder mehrere Abschnitte des Substrats (102) gebildet wird, und wobei ein Verhältnis zwischen der Oberfläche des Teils (108) der Membran (104), der die Bodenwand (113) des Hohlraumes (110) bildet, die in Kontakt mit dem Versteifungselement (117) ist, und der Gesamtoberfläche des Teils (108) der Membran (104), der die Bodenwand (113) des Hohlraumes (110) bildet, zwischen 0,05 und 0,6 liegt.

10. Verfahren nach Anspruch 9, wobei der Hohlraum (110) und das Versteifungselement (117) durch einen selben Ätzschritt von einer Rückseite (111) des Substrats (102) aus ausgeführt werden.

11. Verfahren nach einem der Ansprüche 9 oder 10, wobei das Ausführen der Membran (104) einen Schritt zum Ausführen, auf dem Substrat (102), von mindestens einer Werkstoffschicht (105) beinhaltet, die dazu bestimmt ist, die Membran (104) zu bilden, und auf der danach das pyroelektrische Detektionselement (112) ausgeführt wird.

12. Verfahren nach Anspruch 11, wobei die Werkstoffschicht (105) durch thermisches Oxidieren des Substrats (102), welches mindestens einen Halbleiter beinhaltet, und/oder durch Abscheiden von SiO₂ auf dem Substrat (102) ausgeführt wird.

13. Verfahren nach einem der Ansprüche 11 oder 12, wobei das Ausführen des pyroelektrischen Detektionselements (112) das Durchführen der folgenden Schritte beinhaltet:
- Ausführen mindestens einer ersten Elektrodenschicht (122) auf der Werkstoffschicht (105);
- Ausführen mindestens einer Schicht (124) aus dem pyroelektrischen Werkstoff auf der ersten Elektrodenschicht (122);
- Ausführen mindestens einer zweiten Elektrodenschicht (126) auf der Schicht (124) aus dem pyroelektrischen Werkstoff;
- Strukturieren einer jeden der ersten und zweiten Elektrodenschicht (122, 126) und der Schicht (124) aus dem pyroelektrischen Werkstoff derart, dass die verbleibenden Abschnitte (114, 116, 118) dieser Schichten (122, 124, 126) das pyroelektrische Detektionselement (112) bilden.

14. Verfahren nach einem der Ansprüche 9 oder 10, wobei die Membran (104) durch das Durchführen der folgenden Schritte erhalten wird:
- Ausführen auf dem Substrat (102) mindestens einer ersten Elektrodenschicht (122);
- Ausführen mindestens einer Schicht (124) aus dem pyroelektrischen Werkstoff auf der ersten Elektrodenschicht (122);
- Ausführen mindestens einer zweiten Elektrodenschicht (126) auf der Schicht (124) aus pyroelektrischem Werkstoff;
- Strukturieren der zweiten Elektrodenschicht (126) und der Schicht (124) aus dem pyroelektrischen Werkstoff derart, dass die verbleibenden Abschnitte (116, 118) der zweiten Elektrodenschicht (126) und der Schicht (124) aus dem pyroelektrischen Werkstoff mit der ersten Elektrodenschicht (122) das pyroelektrische Detektionselement (112) bilden;
und wobei die Membran (104) dem pyroelektrischen Detektionselement (112) angehört und mindestens durch die erste Elektrodenschicht (122) gebildet wird.

15. Verfahren nach einem der Ansprüche 13 oder 14, welches weiter zwischen dem Schritt des Abscheidens der zweiten Elektrodenschicht (126) und dem Schritt des Strukturierens einen Schritt des Abscheidens mindestens einer Schicht (128) aus Infrarotstrahlung absorbierendem Werkstoff auf der zweiten Elektrodenschicht (126) beinhaltet, und wobei der Schritt des Strukturierens auch für die Schicht (128) aus Infrarotstrahlung absorbierendem Werkstoff derart durchgeführt wird, dass ein verbleibender Abschnitt (120) dieser Schicht (128) aus Infrarotstrahlung absorbierendem Werkstoff, die auf der zweiten Elektrode (118) angeordnet ist, einem schwarzen Körper des pyroelektrischen Detektionselements (112) angehört.

## Claims

1. Pyroelectric detection device (100), comprising at least:
- a substrate (102);
- a membrane (104) disposed on the substrate (102);
- a pyroelectric detection element (112) disposed on the membrane (104) or forming at least a part of the membrane (104), and comprising at least a portion (116) of pyroelectric material disposed between first and second electrodes (114, 118);
- a cavity (110) passing through the substrate (102), opening facing a part (108) of the member (104) which forms a bottom wall (113) of the cavity (110), and comprising lateral edges (115) formed by the substrate (102);
- an element (117) for stiffening the membrane (104) disposed in the cavity (110), partially filling the cavity (110), joined to the lateral edges (115) of the cavity (110) at at least two distinct anchoring regions (119), and disposed against the membrane (104);
wherein the stiffening element (117) is formed at least by one or more portions of the substrate (102), and wherein a ratio between the surface area of the part (108) of the membrane (104) forming the bottom wall (113) of the cavity (110) which is in contact with the stiffening element (117) and the total surface area of the part (108) of the membrane (108) forming the bottom wall (113) of the cavity (110) is between 0.05 and 0.06.

2. Device (100) according to one of the preceding claims, wherein the stiffening element (117) includes several distinct portions of elongated shape and extending into the cavity (110) between the lateral edges (115) along one or more directions.

3. Device (100) according to one of the preceding claims, wherein the pyroelectric detection element (112) is disposed on the membrane (104) which includes at least one layer (105) of material distinct from the pyroelectric detection element (112).

4. Device (100) according to claim 3, wherein the layer (105) of the membrane (104) includes SiO₂ and/or Si and/or SiN.

5. Device (100) according to one of claims 1 or 2, wherein the membrane (104) forms part of the pyroelectric detection element (112) and is formed at least by the first electrode (114) whereon the portion (116) of piezoelectric material rests.

6. Device (100) according to one of the preceding claims, wherein the pyroelectric detection element (112) includes a black body formed by the second electrode (118) which is configured to receive an incident infrared radiation intended to be detected by the device (100) and/or by a portion (120) of infrared radiation-absorbing material such that the second electrode (118) is disposed between the portion (120) of infrared radiation-absorbing material and the portion (116) of pyroelectric material.

7. Device (100) according to claim 6, wherein the infrared radiation-absorbing material includes TiN and/or Ni-Cr and/or Ni and/or black metal.

8. Device (100) according to one of the preceding claims, wherein:
- the pyroelectric material corresponds to at least one of the following materials: PZT, doped PZT, AIN, KNN, NBT-BT, PMN-PT, LTO, LNO, PVDF and/or
- the first electrode (114) includes a metal and/or a metal oxide, and/or
- the second electrode (118) includes at least one of the following materials: Pt, Ru, Ir, TiW, Au, Ni, Ni-Cr, TiN.

9. Method for producing a pyroelectric detection device (100), comprising at least:
- producing, on a substrate (102), a membrane (104) and a pyroelectric detection element (112) such that it is disposed on the membrane (104) or forms at least a part of the membrane (104), and comprising at least a portion (116) of pyroelectric material disposed between first and second electrodes (114, 118);
- producing at least one cavity (110) passing through the substrate (102), opening facing a part (108) of the member (104) which forms a bottom wall (113) of the cavity (110), and comprising lateral edges (115) formed by the substrate (102);
- producing at least one element (117) for stiffening the membrane (104) disposed in the cavity (110), partially filling the cavity (110), joined to the lateral edges (115) of the cavity (110) at at least two distinct anchoring regions (119), and disposed against the membrane (104);
wherein the stiffening element (117) is formed at least by one or more portions of the substrate (102), and wherein a ratio between the surface area of the part (108) of the membrane (104) forming the bottom wall (113) of the cavity (110) which is in contact with the stiffening element (117) and the total surface area of the part (108) of the membrane (108) forming the bottom wall (113) of the cavity (110) is between 0.05 and 0.06.

10. Method according to claim 9, wherein the cavity (110) and the stiffening element (117) are produced with a single etching step from a rear face (111) of the substrate (102).

11. Method according to one of claims 9 or 10, wherein producing the membrane (104) includes a step of producing, on the substrate (102), at least one layer (105) of material intended to form the membrane (104) and whereon the pyroelectric detection element (112) is subsequently produced.

12. Method according to claim 11, wherein the layer (105) of material is produced by thermal oxidation of the substrate (102) which includes at least one semiconductor, and/or by depositing SiO₂ on the substrate (102).

13. Method according to one of claims 11 or 12, wherein producing the pyroelectric detection element (112) includes implementing the following steps:
- producing at least a first electrode layer (122) on the layer (105) of material;
- producing at least one layer (124) of pyroelectric material on the first electrode layer (122);
- producing at least a second electrode layer (126) on the layer (124) of pyroelectric material;
- structuring each of the first and second electrode layers (122, 126) and the layer (124) of pyroelectric material such that remaining portions (114, 116, 118) of these layers (122, 124, 126) form the pyroelectric detection element (112).

14. Method according to one of claims 9 or 10, wherein the membrane (104) is obtained by implementing the following steps:
- producing, on the substrate (102), at least a first electrode layer (122);
- producing at least one layer (124) of pyroelectric material on the first electrode layer (122);
- producing at least a second electrode layer (126) on the layer (124) of pyroelectric material;
- structuring the second electrode layer (126) and the layer (124) of pyroelectric material such that remaining portions (116, 118) of the second electrode layer (126) and the layer (124) of pyroelectric material form, with the first electrode layer (122), the pyroelectric detection element (112);
and wherein the membrane (104) forms part of the pyroelectric detection element (112) and is formed at least by the first electrode (122).

15. Method according to one of claims 13 or 14, furthermore including, between the step of depositing the second electrode layer (126) and the structuring step, a step of depositing at least one layer (128) of infrared radiation-absorbing material on the second electrode layer (126), and wherein the structuring step is also implemented for the layer (128) of infrared radiation-absorbing material such that a remaining portion (120) of this layer (128) of infrared radiation-absorbing material disposed on the second electrode (118) forms part of a black body of the pyroelectric detection element (112).
